# EUROPEAN PATENT APPLICATION

(11) **EP 3 196 692 A1**
(43) Date of publication of application: **26.07.2017**
(21) Application number: 15842343.4
(22) Date of filing: 05.01.2015
(51) Int. Cl.: G02F 1/1343

(54) **ARRAY SUBSTRATE AND DISPLAY DEVICE**

(30) Priority: 19.09.2014 CN 201410484505
(71) Applicant: BOE Technology Group Co., Ltd., Beijing 100015 (CN)
(72) Inventor: NING, Ce, Beijing 100176 (CN); WU, Chunwei, Beijing 100176 (CN); ZHANG, Yuting, Beijing 100176 (CN)
(74) Representative: Gesthuysen Patent- und Rechtsanwälte
(86) International application number: PCT/CN2015/070089
(87) International publication number: WO 2016/041302

(57) **Abstract**

The present invention relates to the field of display technology, particularly to an array substrate and a display device, for solving the problem that the capacitance values of C_{gc} and/or C_{dc} are relatively large in the prior art. One embodiment of the present invention provides an array substrate, comprising: a gate line, a data line, and a common electrode layer electrically insulated from the gate line and the data line, wherein there is at least one overlapping area between the common electrode layer and the gate line, and/or, there is at least one overlapping area between the common electrode layer and the data line; moreover, the common electrode layer comprises a hollow structure part located in the at least one overlapping area, and the hollow structure part located in the overlapping area comprises at least one hollow area. The embodiment of the present invention can reduce the capacitance values of C_{gc} and/or C_{dc}.

## Description

### FIELD OF THE INVENTION

The present invention relates to the field of display technology, particularly to an array substrate and a display device.

### BACKGROUND OF THE INVENTION

When the array substrate not only comprises a gate line and a data line, but also comprises a common electrode layer electrically insulated from the gate line and the data line, a parasitic capacitance C_{gc} may be formed between the common electrode layer and the gate line, and a parasitic capacitance C_{dc} may be formed between the common electrode layer and the data line.

At present, there may be an overlapping area may between the electrically insulated common electrode layer and the gate line, and there may also be not any overlapping area; wherein, when there is an overlapping area between the common electrode layer and the gate line, the capacitance value of C_{gc} is relatively large. Similarly, when there is an overlapping area between the electrically insulated common electrode layer and the data line, the capacitance value of C_{dc} is relatively large.

When the capacitance value of C_{gc} is relatively large, the electric quantity consumed for charging C_{gc} is also relatively large, such that the power consumption of the array substrate is relatively large; moreover, when the capacitance value of C_{gc} is relatively large, the signal transmitted on the gate line may result in crosstalk with the signal applied on the common electrode layer, thereby resulting in display defect. Similarly, when the capacitance value of C_{dc} is relatively large, the problems of relatively large power consumption and display defect may also occur.

To sum up, at present, when there is an overlapping area between the common electrode layer and the gate line, the capacitance value of C_{gc} is relatively large; and/or, when there is an overlapping area between the common electrode layer and the data line, the capacitance value of C_{dc} is relatively large.

### SUMMARY OF THE INVENTION

The embodiment of the present invention provides an array substrate and a display device, for solving the problem that the capacitance values of C_{gc} and/or C_{dc} are relatively large in the prior art.

On the first aspect, the embodiment of the present invention provides an array substrate, comprising: a gate line, a data line, and a common electrode layer electrically insulated from the gate line and the data line, wherein there is at least one overlapping area between the common electrode layer and the gate line, and/or, there is at least one overlapping area between the common electrode layer and the data line;
the common electrode layer comprises a hollow structure part located in the at least one overlapping area, and the hollow structure part located in the overlapping area comprises at least one hollow area.

Optimally, the hollow structure part located in the overlapping area comprises a plurality of hollow areas;
the plurality of hollow areas are arranged in a matrix.

Optimally, the hollow structure part located in the overlapping area is in a grid structure.

Optimally, each of the hollow areas is in a circular shape.

Optically, the hollow structure part located in the overlapping area comprises one hollow area;
the one hollow area is in a rectangular shape.

Optimally, the hollow area comprised by the hollow structure part located in the overlapping area meets: for any point on the frame of the hollow area, the minimum value of the distance from it to the frame of the overlapping area is not less than 2µm.

Optimally, the common electrode layer, the gate line and the data line are located in different layers respectively, the array substrate further comprises:
intermediate layers located between the film where the gate line locates and the common electrode layer, and between the film where the data line locates and the common electrode layer; wherein the intermediate layers comprise a passivation layer and/or a resin layer, the material of the passivation layer comprises one or more of silicon oxide and silicon nitride.

Optimally, the value of the thickness of the intermediate layer is not less than 2µm.

On the second aspect, the embodiment of the present invention provides a display device, comprising an array substrate as stated in the embodiment of the present invention.

The beneficial effects of the embodiment of the present invention include:
In the embodiment of the present invention, the array substrate comprises a gate line, a data line, and a common electrode layer electrically insulated from the gate line and the data line, wherein there is at least one overlapping area between the common electrode layer and the gate line, and/or, there is at least one overlapping area between the common electrode layer and the data line; moreover, the common electrode layer comprises a hollow structure part located in the at least one overlapping area, and the hollow structure part located in the overlapping area comprises at least one hollow area;
Compared with the prior art, the common electrode layer of the embodiment of the present invention arranges a hollow structure part with hollow areas in the at least one overlapping area, thereby being capable of reducing the actual area of the overlapping area between the common electrode layer and the gate line and/or the data line, and reducing the capacitance values of C_{gc} and/or C_{dc}.

### BRIEF DESCRIPTION OF DRAWINGS

Fig. 1a to Fig. 1d are schematic views of structure of a hollow structure part located in the overlapping area in the embodiment of the present invention;
Fig. 2 is a vertical view of an array substrate comprised by the high advanced dimension switch (HADS) mode display device in the embodiment of the present invention.

### DETAILED DESCRIPTION OF THE INVENTION

In order to explain the solution of the embodiment of the present invention clearly, next, the embodiment of the present invention will be further described specifically in combination with the drawings of the description.

It should be noted that the thickness and shape of the respective films in the drawings do not reflect the real proportion, which are only for explaining the contents of the present invention schematically.

Optimally, the embodiment of the present invention provides an array substrate, comprising: a gate line, a data line, and a common electrode layer electrically insulated from the gate line and the data line, wherein there is at least one overlapping area between the common electrode layer and the gate line, and/or, there is at least one overlapping area between the common electrode layer and the data line;
the common electrode layer comprises a hollow structure part located in the at least one overlapping area, and the hollow structure part located in the overlapping area comprises at least one hollow area.

In implementation, compared with the prior art, in the embodiment of the present invention, the common electrode layer of the embodiment of the present invention arranges a hollow structure part with hollow areas in the at least one overlapping area, thereby being capable of reducing the actual area of the overlapping area between the common electrode layer and the gate line and/or the data line;

Therefore, the embodiment of the present invention can reduce the capacitance values of C_{gc} and/or C_{dc}; thereby being capable of reducing the power consumption of the array substrate to a certain extent, and avoiding occurrence of display defect.

Optimally, the common electrode layer comprises a hollow structure part located in each of the overlapping areas.

In implementation, in the case that the specific structure of the hollow structure part located in the overlapping area is unchanged, the larger the number of the overlapping areas arranged with the hollow structure part is, the smaller the actual area of the overlapping area between the common electrode layer and the gate line and/or the data line is, and the smaller the capacitance value of C_{gc} and/or C_{dc} is; hence, in the case that the specific structure of the hollow structure part located in the overlapping area is unchanged, and when the common electrode layer comprises a hollow structure part located in each of the overlapping areas, the actual area of the overlapping area between the common electrode layer and the gate line and/or the data line is minimum, the capacitance value of C_{gc} and/or C_{dc} is minimum.

Optimally, the size of the hollow structure part located in the overlapping area can match with the size of the corresponding overlapping area; and can also not match with the size of the corresponding overlapping area;

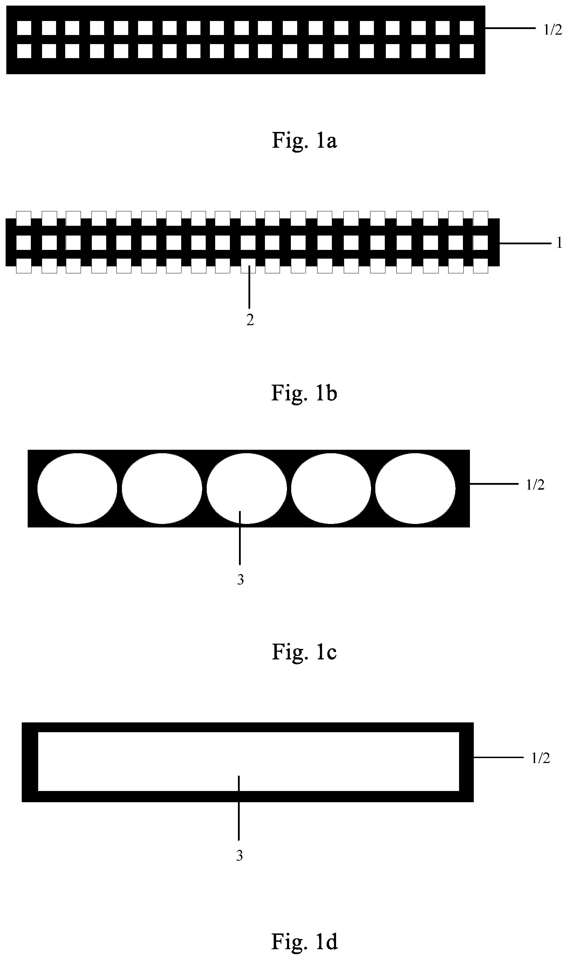

For example, take the hollow structure part located in one of the overlapping areas as the example, as shown in Fig. 1a, the size of the hollow structure part 2 located in the overlapping area 1 matches with the size of the corresponding overlapping area 1; as shown in Fig. 1b, the size of the hollow structure part 2 located in the overlapping area 1 does not match with the size of the corresponding overlapping area 1, here, the size of the size of the hollow structure part 2 located in the overlapping area 1 is slightly larger than the size of the corresponding overlapping area 1.

It should be noted that in the embodiment of the present invention, the hollow structure part located in the overlapping area only needs to meet the requirement of comprising at least one hollow area; while the specific number, shape, size, and arrangement manner of the hollow areas comprised in the hollow structure part located in the overlapping area can be set arbitrarily based on needs.

Optimally, the hollow structure part located in the overlapping area may comprise one hollow area, and may also comprise a plurality of hollow areas.

In implementation, in the case that the size of the hollow area comprised in the hollow structure part located in the overlapping area is unchanged, the larger the number of the overlapping areas arranged with the hollow structure part are, the smaller the actual area of the overlapping area between the common electrode layer and the gate line and/or the data line is, and the smaller the capacitance value of C_{gc} and/or C_{dc} is.

Optimally, the shape of the hollow area comprised in the hollow structure part located in the overlapping area may be a regular shape, and may also be an irregular shape.

In implementation, when the shape of the hollow area comprised in the hollow structure part located in the overlapping area is a regular shape, the fabricating complexity thereof is relatively low.

Optimally, the size of the hollow area comprised in the hollow structure part located in the overlapping area can be set arbitrarily based on needs.

In implementation, in the case that the number of the hollow areas comprised in the hollow structure part located in the overlapping area is unchanged, the larger the hollow area comprised in the hollow structure part located in the overlapping area is, the smaller the actual area of the overlapping area between the common electrode layer and the gate line and/or the data line is, and the smaller the capacitance value of C_{gc} and/or C_{dc} is.

Optimally, when the hollow structure part located in the overlapping area comprises a plurality of hollow areas, the plurality of hollow areas may be arrange regularly, and may also be arranged irregularly.

In implementation, when the plurality of hollow areas comprised in the hollow structure part located in the overlapping area are arranged regularly, the fabricating complexity thereof is relatively low.

Next, the number of the hollow areas comprised in the hollow structure part located in the overlapping area is taken as the basis for classification to explain several optimal implementing modes of the hollow areas comprised in the hollow structure part located in the overlapping area.
I. The hollow structure part located in the overlapping area comprises a plurality of hollow areas.

Optimally, the hollow structure part located in the overlapping area comprises a plurality of hollow areas;

The plurality of hollow areas are arranged in a matrix.

In implementation, when the plurality of hollow areas comprised in the hollow structure part located in the overlapping area are arranged in a matrix, the fabricating complexity thereof is relatively low.

Optimally, as shown in Fig. 1a, the hollow structure part 2 located in the overlapping area 1 is in a grid structure.

In implementation, when the hollow structure part located in the overlapping area is in a grid structure, the fabricating complexity thereof is relatively low.

Optimally, as shown in Fig. 1c, the respective hollow areas 3 comprised in the hollow structure part 2 located in the overlapping area 1 are in a circular shape.

In implementation, the gate line and the data line are generally in a strip shape, when there is an overlapping area between the common electrode layer and the gate line and/or the data line, the overlapping area between the common electrode layer and the gate line and/or the data line is generally in a rectangular shape; hence, compared with other shapes of the hollow area, when the respective hollow areas are in a circular shape, it can be ensured that the actual area of the overlapping area between the common electrode layer and the gate line and/or the data line is relatively small, and the capacitance value of C_{gc} and/or C_{dc} is relatively small.

II. The hollow structure part located in the overlapping area comprises one hollow area.

Optimally, as shown in Fig. 1d, the hollow structure part 2 located in the overlapping area 1 comprises one hollow area 3;

The hollow area 3 is in a rectangular shape.

In implementation, the gate line and the data line are generally in a strip shape, when there is an overlapping area between the common electrode layer and the gate line and/or the data line, the overlapping area between the common electrode layer and the gate line and/or the data line is generally in a rectangular shape; hence, compared with other shapes of the hollow area, when the hollow area is in a rectangular shape, it can be ensured that the actual area of the overlapping area between the common electrode layer and the gate line and/or the data line is relatively small, the he capacitance value of C_{gc} and/or C_{dc} is relatively small, in addition, the fabricating complexity is also relatively low.

Optimally, the hollow area comprised in the hollow structure part located in the overlapping area meets: for any point on the frame of the hollow area, the minimum value of the distance from it to the frame of the overlapping area is not less than 2µm.

In implementation, for any point on the frame of the hollow area, the minimum value of the distance from it to the frame of the overlapping area is not less than 2µm; the occurrence of light leakage can be avoided to a certain extent.

Optimally, the common electrode layer, the gate line and the data line are located in different layers respectively, the array substrate further comprises:
intermediate layers located between the film where the gate line locates and the common electrode layer, and between the film where the data line locates and the common electrode layer; wherein the intermediate layers comprise a passivation layer and/or a resin layer, the material of the passivation layer comprises one or more of silicon oxide and silicon nitride.

In implementation, by fabricating intermediate layers between the film where the gate line locates and the common electrode layer, and between the film where the data line locates and the common electrode layer, the distance between the film where the data line locates and the common electrode layer can be increased, and the distance between the film where the gate line locates and the common electrode layer can be increased.

However, the inventor of the present case has noticed in the invention process that: the larger the distance between the common electrode layer and the film where the gate line locates is, the smaller the capacitance value of C_{gc} is; similarly, the larger the distance between the common electrode layer and the film where the data line locates is, the smaller the capacitance value of C_{dc} is; hence, the embodiment of the present invention can reduce the capacitance values of C_{gc} and C_{dc}; Thereby, the power consumption of the array substrate can be reduced to a certain extent, and the occurrence of display defect can be avoided.

It should be noted that according to the difference in film order of the common electrode layer, the film where the gate line locates and the film where the data line locates, the intermediate layer located between the film where the gate line locates and the common electrode layer, and the intermediate layer located between the film where the data line locates and the common electrode layer may be the same film, and may also be different films;

For example, when the common electrode layer is located between the film where the gate line locates and the film where the data line locates, the intermediate layer (the first intermediate layer) located between the film where the gate line locates and the common electrode layer, and the intermediate layer (the second intermediate layer) located between the film where the data line locates and the common electrode layer are different films;

When the film where the gate line locates is located between the common electrode layer and the film where the data line locates, and an intermediate layer is arranged between the film where the gate line locates and the common electrode layer, the intermediate layer located between the film where the gate line locates and the common electrode layer, and the intermediate layer located between the film where the data line locates and the common electrode layer are the same film;

When the film where the data line locates is located between the common electrode layer and the film where the gate line locates, and an intermediate layer is arranged between the film where the data line locates and the common electrode layer, the intermediate layer located between the film where the gate line locates and the common electrode layer, and the intermediate layer located between the film where the data line locates and the common electrode layer are the same film.

In specific implementation, the thickness of the intermediate layer can be set based on application needs; for example, when the thickness of the intermediate layer is set, the effect of reducing the capacitance values of C_{gc} and C_{dc} and the thickness of the array substrate are considered comprehensively.

Optimally, the film number of the passivation layer and/or the resin layer can be increased or decreased to obtain an intermediate layer with a preset thickness.

Optimally, the value of the thickness of the intermediate layer is not less than 2µm.

In implementation, the value of the thickness of the intermediate layer is not less than 2µm, it can ensure a better effect of reducing the capacitance values of C_{gc} and C_{dc}.

It should be noted that the array substrate in the embodiment of the present invention may be any array substrate that meets the following conditions: which comprises: a gate line, a data line, and a common electrode layer electrically insulated from the gate line and the data line, wherein there is at least one overlapping area between the common electrode layer and the gate line, and/or, there is at least one overlapping area between the common electrode layer and the data line;
such as, an array substrate comprised by a HADS mode display device, or, an array substrate comprised by an innovative advanced dimension switch (IADS) mode display device.

### Embodiment

Next, the structure of a pixel unit comprised by the array substrate in the HADS mode display device is taken as an example to explain the solution of the embodiment of the present invention.

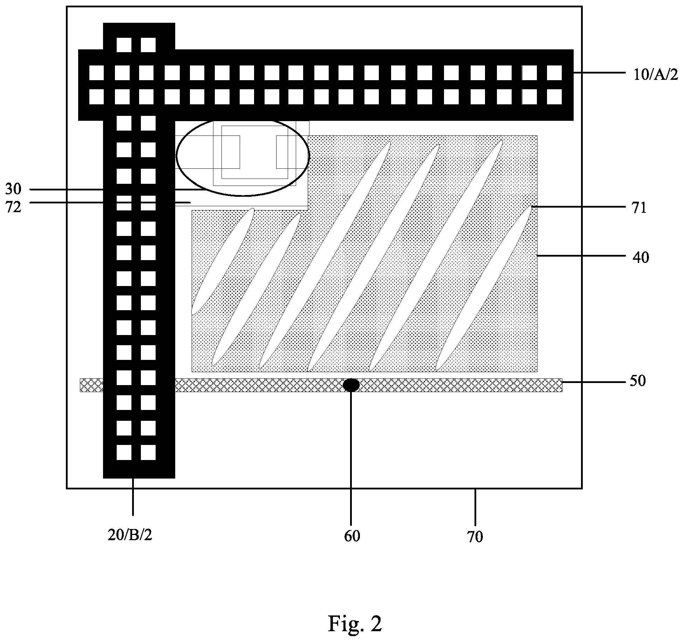

As shown in Fig. 2, the array substrate of the HADS mode display device comprises: a gate line 10 and a data line 20 intersected with each other to define a pixel unit, a thin film transistor (TFT) 30 and a pixel electrode 40 located in the pixel unit and electrically connected with each other, a common electrode line 50 arranged in the same layer as the gate line 10 and insulated from each other, and a common electrode layer 70 electrically connected with the common electrode line 50 through a via hole 60.

There is an overlapping area A between the electrically insulated common electrode layer 70 and the gate line 10, and there is an overlapping area B between the electrically insulated common electrode layer 70 and the data line 20.

The common electrode layer 70 comprises a plurality of hollow areas 71 located exactly above the pixel electrode 40, so that an edge electric field can be formed between the common electrode layer 70 and the pixel electrode 40; and the common electrode layer 70 comprises a hollow area 72 located exactly above the TFT 30, so as to avoid the common electrode layer 70 from interfering the TFT 30. In addition, the common electrode layer 70 further comprises hollow structure parts 2 with hollow areas located in the overlapping area A and the overlapping area B, and the hollow structure parts 2 located in the overlapping area A and the overlapping area B are both in a grid structure.

In implementation, there is an overlapping area between the electrically insulated common electrode layer and the gate line, and there is an overlapping area between the electrically insulated common electrode layer and the data line, hence, the capacitance values of C_{gc} and C_{dc} are relatively large; and since the common electrode layer arranges a hollow structure part in a grid structure in this overlapping area, the actual area of the overlapping area between the common electrode layer and the gate line can be reduced, and the actual area of the overlapping area between the common electrode layer and the data line can be reduced, thereby being capable of reducing the capacitance values of C_{gc} and C_{dc}.

Optimally, based on the same inventive concept, the embodiment of the present invention provides a display device, comprising: an array substrate provided by the embodiment of the present invention.

In implementation, the capacitance values of C_{gc} and C_{dc} in the array substrate in the embodiment of the present invention are reduced, such that the power consumption of the array substrate, and the occurrence probability of the problem of display defect are reduced to a certain extent. Therefore, the power consumption of the array substrate, and the occurrence probability of the problem of display defect of the display device comprising the array substrate in the embodiment of the present invention are also reduced to a certain extent.

Optimally, the display device may be any product or component with the display function such as a liquid crystal panel, electronic paper, an OLED panel, a mobile phone, a tablet computer, a television, a display, a laptop, a digital photo frame, a navigator.

Although the preferred embodiments of the present invention have been described, the skilled person in the art, once having learnt the basic inventive concept, can make additional variations and modifications to these embodiments. So, the claims attached intend to be construed as comprising the preferred embodiments and all the variations and modifications falling within the scope of the present invention.

Apparently, the skilled person in the art can make various modifications and variations to the present invention without departing from the spirit and scope of the present invention. In this way, provided that these modifications and variations of the present invention belong to the scope of the claims of the present invention and the equivalent technologies thereof, the present invention also intends to contain these modifications and variations.

## Claims

1. An array substrate, comprising: a gate line, a data line, and a common electrode layer electrically insulated from the gate line and the data line, wherein there is at least one overlapping area between the common electrode layer and the gate line, and/or, there is at least one overlapping area between the common electrode layer and the data line, **characterized in that**,
the common electrode layer comprises a hollow structure part located in the at least one overlapping area, and the hollow structure part located in the overlapping area comprises at least one hollow area.

2. The array substrate as claimed in claim 1, **characterized in that** the hollow structure part located in the overlapping area comprises a plurality of hollow areas;
the plurality of hollow areas are arranged in a matrix.

3. The array substrate as claimed in claim 2, **characterized in that** the hollow structure part located in the overlapping area is in a grid structure.

4. The array substrate as claimed in claim 2, **characterized in that** each of the hollow areas is in a circular shape.

5. The array substrate as claimed in claim 1, **characterized in that** the hollow structure part located in the overlapping area comprises one hollow area;
the one hollow area is in a rectangular shape.

6. The array substrate as claimed in any of claims 1 to 5, **characterized in that** the hollow area comprised by the hollow structure part located in the overlapping area meets: for any point on a frame of the hollow area, a minimum value of a distance from it to the frame of the overlapping area is not less than 2µm.

7. The array substrate as claimed in any of claims 1 to 5, **characterized in that** the common electrode layer, the gate line and the data line are located in different layers respectively, the array substrate further comprises:
intermediate layers located between the film where the gate line locates and the common electrode layer, and between the film where the data line locates and the common electrode layer; wherein the intermediate layers comprise a passivation layer and/or a resin layer, a material of the passivation layer comprises one or more of silicon oxide and silicon nitride.

8. The array substrate as claimed in claim 7, **characterized in that** a value of the thickness of the intermediate layer is not less than 2µm.

9. A display device, **characterized in that**, comprising an array substrate as claimed in any of claims 1 to 8.
